# EUROPEAN PATENT APPLICATION

(11) **EP 4 513 240 A1**
(43) Date of publication of application: **26.02.2025**
(21) Application number: 23791689.5
(22) Date of filing: 06.04.2023
(51) Int. Cl.: G02B 5/20, F21V 3/00, F21V 3/08, F21V 3/12, F21V 9/00, F21V 9/08, F21V 9/32, H01L 33/50, F21Y 115/10, F21Y 115/30

(54) **NEAR-INFRARED LIGHT-EMITTING DEVICE AND METHOD FOR ADJUSTING INTENSITY RATIO OF NEAR-INFRARED RAY AND VISIBLE RAY**

(30) Priority: 21.04.2022 JP 2022070021
(71) Applicant: Panasonic Intellectual Property Management Co., Ltd., Osaka-shi, Osaka 540-6207 (JP)
(72) Inventor: NITTA Mitsuru, Kadoma-shi, Osaka 571-0057 (JP); SHIGITANI Ryosuke, Kadoma-shi, Osaka 571-0057 (JP); OSHIO Shozo, Kadoma-shi, Osaka 571-0057 (JP)
(74) Representative: Müller-Boré & Partner Patentanwälte PartG mbB
(86) International application number: PCT/JP2023/014219
(87) International publication number: WO 2023/204038

(57) **Abstract**

Provided is a near-infrared light emitting device (100) including a solid-state light emitting element (1) that emits blue primary light (10), a wavelength converter (2) that converts the primary light into near-infrared wavelength-converted light (11), an organic polymer member (3) through which mixed light (12) of the primary light and the wavelength-converted light is transmitted, and outputs the mixed light transmitted through the organic polymer member, as output light (13). The organic polymer member has a thickness of 3 µm or more and less than 300 µm, a light transmittance of less than 0.1% at a wavelength of 400 nm or less, a light transmittance of less than 1% at or below a wavelength of the emission peak of the primary light, and a light transmittance of less than 30% at a wavelength of 500 nm or less, a light transmittance of 75% or more and less than 100% within a wavelength range of 750 nm or more and less than 1,100 nm, and a light transmittance in 10 nm increments within a wavelength range of 500 nm or more and 750 nm or less increasing as wavelength increases.

## Description

### TECHNICAL FIELD

The present invention relates to a near-infrared light emitting device, and a method for adjusting an intensity ratio between a near-infrared ray and a visible ray.

### BACKGROUND ART

There is a conventionally known near-infrared light emitting device that has a form using a solid-state light emitting element and a near-infrared phosphor, and emits a near-infrared ray. Many near-infrared light emitting devices having the form actually output not only a near-infrared ray invisible to human eyes, but also a visible ray that is perceivable to human eyes. Specifically, the near-infrared light emitting device outputs, as a visible ray, primary light (e.g., blue light) emitted by the solid-state light emitting element, and a deep red light component on the short wavelength side of fluorescence emitted by the near-infrared phosphor, in no small amounts.

As an example of a near-infrared light emitting device, Patent Literature 1 discloses a light emitting device that includes a blue light emitting diode, a first light emitting material made from La_{2.98}Gd_{0.02}Ga_{4.76}Al_{0.2}SiO₁₄:Cr_{0.04}, a near-infrared emitting phosphor, and a second light emitting material made from Gd_{2.85}Sc_{1.75}Lu_{0.3}Ga₃O₁₂:Cr_{0.1}, a near-infrared emitting phosphor.

### CITATION LIST

### PATENT LITERATURE

Patent Literature 1: International Publication WO 2019/063297

### SUMMARY OF INVENTION

In the conventional near-infrared light emitting device as described above, it is possible to know a lit state and an unlit state of the device by recognizing visible light with human eyes. However, there is an issue in the near-infrared light emitting device where visible light seen by human eyes is generally different from natural light, so that a color tone gives discomfort. Thus, the visible light is adjusted to a color tone close to that of natural light by using a dye absorbing filter or an interference filter. However, when a dye absorbing filter or an interference filter is used, there are issues such as an increase in manufacturing cost, and difficulty in making a light emitting part thin.

As another means, the visible light is converted to have a color tone close to that of natural light by using a phosphor sheet. However, since such a phosphor sheet efficiently absorbs primary light emitted by a solid-state light emitting element, and converts it into visible light, there is an issue where the intensity of a near-infrared ray decreases and the intensity of the natural light becomes excessive.

The present invention has been made in consideration of the above issues, which are inherent in the related art. An object of the present invention is to provide a near-infrared light emitting device that enables a lit state or an unlit state to be easily recognized, gives little discomfort with respect to visible light when lit, and is capable of efficiently outputting a near-infrared ray. It is also an object of the present invention to provide a method for adjusting an intensity ratio between a near-infrared ray and a visible ray.

In response to the above issues, a near-infrared light emitting device according to a first aspect of the present invention includes: a solid-state light emitting element that emits primary light having an emission peak within a wavelength range of 420 nm or more and less than 500 nm; a wavelength converter that converts the primary light into wavelength-converted light having a fluorescence peak within a wavelength range of 750 nm or more and less than 2,500 nm; and an organic polymer member through which mixed light of the primary light emitted by the solid-state light emitting element and the wavelength-converted light emitted by the wavelength converter is transmitted, and outputs the mixed light transmitted through the organic polymer member, as output light. The organic polymer member has a thickness of 3 µm or more and less than 300 µm, a light transmittance of less than 0.1% at a wavelength of 400 nm or less, a light transmittance of less than 1% at or below a wavelength of the emission peak of the primary light, and a light transmittance of less than 30% at a wavelength of 500 nm or less, a light transmittance of 75% or more and less than 100% within a wavelength range of 750 nm or more and less than 1,100 nm, and a light transmittance in 10 nm increments within a wavelength range of 500 nm or more and 750 nm or less increasing as wavelength increases.

A near-infrared light emitting device according to a second aspect of the present invention includes: a solid-state light emitting element that emits primary light having an emission peak within a wavelength range of 420 nm or more and less than 500 nm; a wavelength converter that converts the primary light into wavelength-converted light having a fluorescence peak within a wavelength range of 750 nm or more and less than 2,500 nm; and an organic polymer member through which mixed light of the primary light emitted by the solid-state light emitting element and the wavelength-converted light emitted by the wavelength converter is transmitted, and that includes aromatic polyimide, and outputs the mixed light transmitted through the organic polymer member, as output light.

A method for adjusting an intensity ratio between a near-infrared ray and a visible ray according to a third aspect of the present invention includes: a step of causing mixed light including: primary light that has an emission peak within a wavelength range of 420 nm or more and less than 500 nm; and wavelength-converted light that is obtained by performing wavelength conversion of the primary light and that has a fluorescence peak within a wavelength range of 750 nm or more and less than 2,500 nm, to be transmitted through an organic polymer member; and a step of outputting the mixed light transmitted through the organic polymer member, as output light. The organic polymer member has a thickness of 3 µm or more and less than 300 µm, a light transmittance of less than 0.1% at a wavelength of 400 nm or less, a light transmittance of less than 1% at or below a wavelength of the emission peak of the primary light, and a light transmittance of less than 30% at a wavelength of 500 nm or less, a light transmittance of 75% or more and less than 100% within a wavelength range of 750 nm or more and less than 1,100 nm, and a light transmittance in 10 nm increments within a wavelength range of 500 nm or more and 750 nm or less increasing as a wavelength increases.

### BRIEF DESCRIPTION OF DRAWINGS

[Fig. 1] Fig. 1 is a schematic view illustrating a configuration of a near-infrared light emitting device according to the present embodiment.
[Fig. 2] Fig. 2 is a cross-sectional view schematically illustrating an example of the near-infrared light emitting device according to the present embodiment.
[Fig. 3] Fig. 3 is a cross-sectional view schematically illustrating another example of the near-infrared light emitting device according to the present embodiment.
[Fig. 4] Fig. 4 is a cross-sectional view schematically illustrating another example of a near-infrared light emitting device according to the present embodiment.
[Fig. 5] Fig. 5 is a cross-sectional view schematically illustrating another example of a near-infrared light emitting device according to the present embodiment.
[Fig. 6] Fig. 6 is a cross-sectional view schematically illustrating another example of a near-infrared light emitting device according to the present embodiment.
[Fig. 7A] Fig. 7A is a graph illustrating light transmittances in a wavelength range of 400 nm to 1,100 nm for an organic polymer member including aromatic polyimide.
[Fig. 7B] Fig. 7B is a graph illustrating light transmittances in a wavelength range of 400 nm to 600 nm for an organic polymer member including aromatic polyimide.
[Fig. 7C] Fig. 7C is an enlarged graph of the graph in Fig. 7B.
[Fig. 8A] Fig. 8A is a graph illustrating spectral distributions of output light outputted from near-infrared light emitting devices of example 1, comparative example 1, and comparative example 2.
[Fig. 8B] Fig. 8B is an enlarged graph of the graph in Fig. 8A.
[Fig. 9A] Fig. 9A is a graph illustrating spectral distributions of output light outputted from near-infrared light emitting devices of examples 2 to 6, and comparative example 3.
[Fig. 9B] Fig. 9B is an enlargement of the graph in Fig. 9A.
[Fig. 10A] Fig. 10A illustrates tones of output light outputted from the near-infrared light emitting devices of examples 3, 5, 7, 8, and 9, and comparative example 3, on a CIE chromaticity diagram.
[Fig. 10B] Fig. 10B is an enlarged view of Fig. 10A.

### DESCRIPTION OF EMBODIMENTS

Referring to the drawings, a detailed description is given below of a near-infrared light emitting device, and a method for adjusting an intensity ratio between a near-infrared ray and a visible ray according to the present embodiment. Note that dimensional ratios in the drawings are exaggerated for convenience of the description and may be different from actual ratios. The embodiments described below are all preferred specific examples. Thus, numerical values, shapes, materials, components, arrangement positions and connection configurations of components, and the like in the following embodiments are merely examples, and are not intended to limit the embodiments.

### [Near-infrared light emitting device]

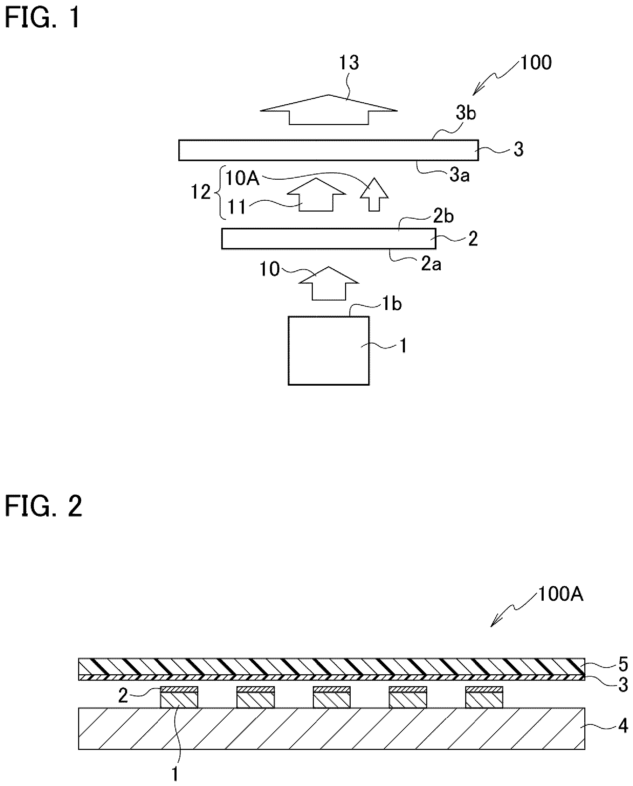

As illustrated in Fig. 1, a near-infrared light emitting device 100 according to the present embodiment includes a solid-state light emitting element 1 that emits primary light 10, and a wavelength converter 2 that, after receiving the primary light 10, converts at least part of the primary light 10 into wavelength-converted light 11, and emits it. The wavelength converter 2 receives the primary light 10 on a main light receiving surface 2a, and emits primary light 10A and the wavelength-converted light 11 from a main light emitting surface 2b. The light emitting device 100 outputs a light component of mixed light 12 of the primary light 10A and the wavelength-converted light 11, as output light 13.

The primary light 10 emitted by the solid-state light emitting element 1 is light having an emission peak within a blue wavelength range of 420 nm or more and less than 500 nm, preferably a blue wavelength range of 440 nm or more and less than 470 nm. Specifically, the solid-state light emitting element 1 is a blue light emitting element that emits light having a maximum intensity value within a wavelength range of 420 nm or more and less than 500 nm, preferably a wavelength range of 440 nm or more and less than 470 nm. By irradiating a phosphor of the wavelength converter 2 with blue light emitted by the solid-state light emitting element 1, a near-infrared component can be easily obtained as wavelength-converted light of the phosphor. Since the solid-state light emitting element 1, which emits blue light, is easy to obtain, the light emitting device 100 is advantageous for industrial production.

The solid-state light emitting element 1 can be a light emitting diode. Since the light emitting diode has a relatively wide emission spectrum half-width, it emits not only a blue light component but also a small amount of a blue-green to green light component. Thus, the output light 13 including the green light component can be obtained without using a green phosphor emitting green fluorescence. Note that the solid-state light emitting element 1 may be a laser diode. Examples of the laser diode used include an edge emitting laser (EEL) and a vertical cavity surface emitting laser (VCSEL).

Preferably, multiple solid-state light emitting elements 1 are used. Thus, the output of the primary light 10 can be increased, and the light emitting device 100 is advantageous for increasing the output. The light energy density of the primary light 10 emitted from the solid-state light emitting element 1 preferably exceeds 0.3 W/mm², and more preferably exceeds 1.0 W/mm². In this manner, the light energy density of the primary light 10 is large, and thus the output light 13 having a relatively high intensity can be emitted. Note that an upper bound of the light energy density of the primary light 10 emitted by the solid-state light emitting element 1 is not particularly limited, and may be, for example, 30 W/mm².

The wavelength-converted light 11 emitted by the wavelength converter 2 is fluorescence having a fluorescence peak within a wavelength range of 750 nm or more and less than 2,500 nm, preferably a wavelength range of 780 nm or more and less than 1,000 nm, and particularly preferably a wavelength range of 800 nm or more and less than 950 nm. The wavelength converter 2 preferably includes at least an inorganic phosphor that emits fluorescence. Thus, the wavelength converter 2 can be formed using an orthodox phosphor that emits fluorescence having a peak in a wavelength region of deep red to near infrared. Therefore, the light emitting device 100 is advantageous in efficient manufacturing by using existing techniques.

The inorganic phosphor contained in the wavelength converter 2 preferably includes at least a near-infrared phosphor having a fluorescence peak within a wavelength range of 780 nm or more and less than 2,500 nm, preferably a wavelength range of 780 nm or more and less than 1,000 nm, and more preferably a wavelength range of 800 nm or more and less than 950 nm. Thus, the wavelength converter 2 can be easily obtained, which emits fluorescence having a large intensity of a near-infrared component.

The wavelength converter 2 can be obtained by sealing a near-infrared phosphor with a silicone resin. The wavelength converter 2 may be an all-inorganic wavelength converter obtained by sealing a near-infrared phosphor with a low-melting glass. Furthermore, the wavelength converter 2 can be an all-inorganic wavelength converter made mainly from a near-infrared phosphor using a binder or the like. The wavelength converter 2 can be a sintered body obtained by sintering a near-infrared phosphor, that is, a fluorescent ceramic.

The thickness of the wavelength converter 2 is not particularly limited, but the maximum thickness is preferably 100 µm or more and less than 5 mm, and more preferably 200 µm or more and less than 1 mm. The wavelength converter 2 preferably has translucency. Consequently, the primary light 10 and a light component that is wavelength-converted in the wavelength converter 2 can be transmitted through the wavelength converter 2 in order to be emitted.

As a near-infrared phosphor included in the wavelength converter 2, for example, an inorganic phosphor may be used that has a fluorescence peak within a wavelength range of 750 nm or more and less than 1,500 nm, particularly 780 nm or more and less than 900 nm. Alternatively, as a near-infrared phosphor included in the wavelength converter 2, an inorganic phosphor may be used that has a fluorescence peak within a wavelength range of 900 nm or more and less than 1,700 nm. As the near-infrared phosphor, it is preferable to use a type of phosphor that is particularly referred to as "localized center type", where absorption and emission of light are caused by transition within one metal ion or ion group. Since such a near-infrared phosphor is easy to manufacture and procure, it is advantageous in industrial production.

Representative examples of near-infrared phosphors include a phosphor activated with a transition metal ion, and a phosphor activated with a rare earth ion. Specifically, the near-infrared phosphor may be at least one of a Cr³⁺ activated phosphor or a rare earth-activated phosphor. The rare earth-activated phosphor may be a phosphor activated with at least one selected from the group consisting of Tm³⁺, Er³⁺, Nd³⁺, and Yb³⁺. Note that the rare earth-activated phosphor preferably further contains a transition metal ion, such as Cr³⁺, which absorbs blue light well, because an absorption rate of the primary light 10, which is blue, may be low.

Some Cr³⁺ activated phosphors have a fluorescence peak at one wavelength selected from, for example, 790 nm, 800 nm, 825 nm, 850 nm, 880 nm, 925 nm, 950 nm, 970 nm, and 1,035 nm. Thus, one suitable for a particular purpose or application may be selected appropriately from these phosphors.

Tm³⁺ activated phosphors, which are rare earth-activated phosphors, have a property of having fluorescence peaks in the form of emission lines at approximately 785 nm, 800 nm, and 820 nm. Er³⁺ activated phosphors have a property of having fluorescence peaks in the form of emission lines at approximately 970 nm, 1,005 nm, 1,470 nm, 1,530 nm, 1,570 nm, 1,615 nm, and 1,645 nm. Nd³⁺ activated phosphors have a property of having fluorescence peaks in the form of emission lines at approximately 880 nm, 935 nm, 1,060 nm, 1,105 nm, 1,335 nm, and 1,420 nm. Yb³⁺ activated phosphors have a property of having fluorescence peaks in the form of emission lines at approximately 970 nm, 1,000 nm, and 1,025 nm. Thus, one suitable for a particular purpose or application may be selected appropriately from these phosphors.

The preferred fluorescent ion in near-infrared phosphors is Cr³⁺. By using Cr³⁺ as the fluorescent ion, it becomes easy to obtain a near-infrared phosphor that absorbs blue light and converts it into a near-infrared component. It also becomes easy to change an optical absorption peak wavelength and/or a fluorescence peak wavelength, depending on the type of host, which is advantageous in changing an excitation spectral shape and a fluorescence spectral shape.

The near-infrared phosphor is preferably a phosphor made from a metal complex oxide activated with Cr³⁺. Specifically, the near-infrared phosphor is preferably a phosphor that includes, as a host, at least one member selected from the group consisting of a borate, a phosphate, a silicate, an aluminate, a gallate salt, a germanate, a tungstate, and a metal oxide, and is activated with Cr³⁺. The near-infrared phosphor is also preferably a phosphor that includes, as a host, a solid solution of a borate, a phosphate, a silicate, an aluminate, a gallate salt, a germanate, a tungstate, or a metal oxide, and is activated with Cr³⁺. Such a near-infrared phosphor can be at least one selected from the group consisting of CeSc₃(BO₃)₄:Cr³⁺, (La,Y,Sc)₄(BO₃)₄:Cr³⁺, LaSc₃(BO₃)₄:Cr³⁺, ScBO₃:Cr³⁺, KInP₂O₇:Cr³⁺, Sr₃InP₃O₁₂:Cr³⁺, Sr₉In(PO₄)₇:Cr³⁺, NaScSi₂O₆:Cr³⁺, Mg₂Al₄Si₅O₁₈:Cr³⁺, La₃(Ga,Gd)₅GeO₁₄:Cr³⁺, La₃(Ga,Al)₅SiO₁₄:Cr³⁺, LaMgGa₁₁O₁₉:Cr³⁺, Mg₃Ga₂GeO₈:Cr³⁺, Li(In,Sc)Ge₂O₆:Cr³⁺, Zn₃(Ga,Al)Ge₂O₁₀:Cr³⁺, LiMg₂InGe₂O₈:Cr³⁺, NaCa₂GaGe₅O₁₄:Cr³⁺, NaGdMgWO₆:Cr³⁺, (Ga,Sc)₂O₃:Cr³⁺, LaLuO₃:Cr³⁺, Ba₃Sc₄O₉:Cr³⁺, Zn₂SnO₄:Cr³⁺, LiIn₂SbO₆:Cr³⁺, and LiSrAlF₆:Cr³⁺. The near-infrared phosphor may be a solid solution having a phosphor described above as an end component.

Note that from the viewpoint of crystal structure, the near-infrared phosphor can be appropriately selected from, for example, a CsCl type or related structure, an NaCl type or related structure, a ZnS type or related structure, an NiAs type or related structure, a perovskite type or related structure, a spinel or related structure, a corundum or related structure, a β-tungsten type or related structure, and the like.

The near-infrared phosphor is preferably a phosphor having a garnet type crystal structure which has many practical results. The garnet type crystal structure is related to the β-tungsten type structure. A phosphor that has a garnet type crystal structure and is activated with Cr³⁺ is, for example, represented by a general formula of RE₃B'₂(AlO₄)₃:Cr³⁺ and RE₃B'₂(GaO₄)₃:Cr³⁺. Note that RE denotes a rare earth element, and B' is at least one element selected from Al, Ga, and Sc. An example of the near-infrared phosphor is a phosphor obtained by substituting a part of a combination of Ln³⁺-B'³⁺ in a crystal constituting the above-described garnet phosphor with a combination of M²⁺-Si⁴⁺. Note that M denotes an alkaline earth metal, and is at least one element selected from the group consisting of Ca, Sr, and Ba. The near-infrared phosphor may be a solid solution of garnet phosphors described above.

The near-infrared phosphor is preferably at least one of a rare earth aluminum garnet phosphor or a rare earth gallium garnet phosphor. Specifically, the near-infrared phosphor is preferably at least one selected from the group consisting of Y₃Al₂(AlO₄)₃:Cr³⁺, La₃Al₂(AlO₄)₃:Cr³⁺, Gd₃Al₂(AlO₄)₃:Cr³⁺, Y₃Ga₂(AlO₄)₃Cr³⁺, La₃Ga₂(AlO₄)₃:Cr³⁺, Gd₃Ga₂(AlO₄)₃:Cr³⁺, Y₃Sc₂(AlO₄)₃:Cr³⁺, La₃Sc₂(AlO₄)₃:Cr³⁺, Gd₃Sc₂(AlO₄)₃:Cr³⁺, Y₃Ga₂(GaO₄)₃:Cr³⁺, La₃Ga₂(GaO₄)₃:Cr³⁺, Gd₃Ga₂(GaO₄)₃:Cr³⁺, Y₃Sc₂(GaO₄)₃:Cr³⁺, La₃Sc₂(GaO₄)₃:Cr³⁺, and Gd₃Sc₂(GaO₄)₃:Cr³⁺. The near-infrared phosphor may be a solid solution having a phosphor described above as an end component.

As described above, the near-infrared light emitting device 100 according to the present embodiment includes, in addition to the solid-state light emitting element 1 and the wavelength converter 2, an organic polymer member 3 through which the mixed light 12 of the primary light 10A emitted by the solid-state light emitting element 1, and the wavelength-converted light 11 emitted by the wavelength converter 2 is transmitted. In the light emitting device 100, after the mixed light 12 is transmitted through the organic polymer member 3, the transmitted light is output as the output light 13.

Figs. 2 to 6 schematically illustrate configurations of near-infrared light emitting devices 100A to 100E according to the present embodiment. The light emitting devices 100A to 100E include multiple solid-state light emitting elements 1. The solid-state light emitting elements 1 are mounted on the surface of a substrate 4. The wavelength converter 2 is arranged to face the solid-state light emitting elements 1. The organic polymer member 3 is disposed on the wavelength converter 2 on the opposite side from the solid-state light emitting elements 1. Thus, in the light emitting device 100, the solid-state light emitting elements 1, the wavelength converter 2, and the organic polymer member 3 overlap in this order.

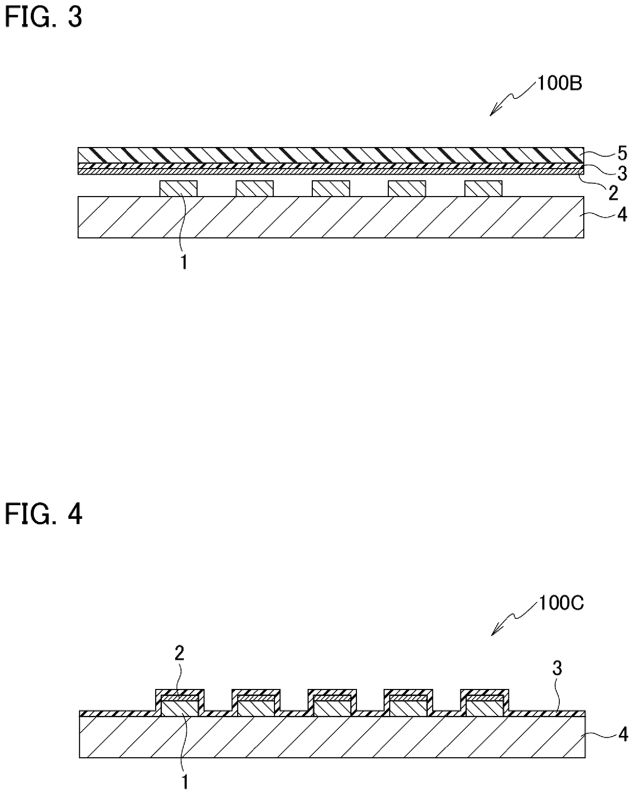

As illustrated in Fig. 2, the organic polymer member 3 can be arranged to be spaced apart from the wavelength converter 2. That is, the organic polymer member 3 and the wavelength converter 2 can be arranged in such a manner that a gap exists between a main light receiving surface 3a of the organic polymer member 3 and the main light emitting surface 2b of the wavelength converter 2. As illustrated in Figs. 3 to 6, the organic polymer member 3 can be arranged to be in close contact with the wavelength converter 2. That is, the organic polymer member 3 and the wavelength converter 2 can be arranged in such a manner that the main light receiving surface 3a of the organic polymer member 3 and the main light emitting surface 2b of the wavelength converter 2 are in contact with each other.

As illustrated in Fig. 4, the organic polymer member 3 can be also arranged to enclose the solid-state light emitting element 1 and the wavelength converter 2. That is, the organic polymer member 3 can be arranged to cover a mounting surface of the substrate 4, the side surfaces of the solid-state light emitting element 1 and the wavelength converter 2, and the main light emitting surface 2b of the wavelength converter 2.

As illustrated in Fig. 2, the main light receiving surface 3a of the organic polymer member 3, which receives the mixed light 12 of the primary light 10A and the wavelength-converted light 11, can have a larger area than the main light emitting surface 2b of the wavelength converter 2, which emits the mixed light 12. As illustrated in Figs. 3, 5, and 6, the main light receiving surface 3a of the organic polymer member 3 can have a substantially similar area as the main light emitting surface 2b of the wavelength converter 2.

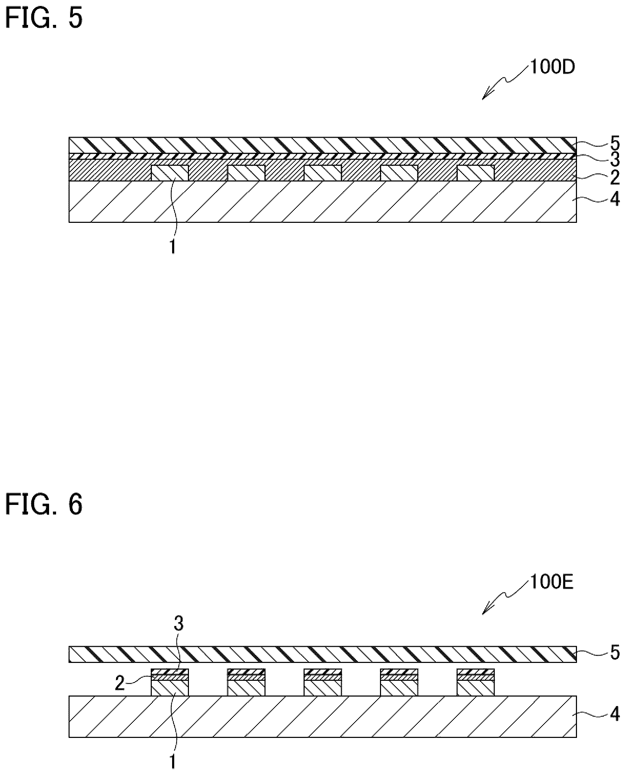

Note that as illustrated in Figs. 1 and 3, the wavelength converter 2 can also be spaced apart from the solid-state light emitting element 1. As illustrated in Figs. 2, 4, 5 and 6, the wavelength converter 2 can also be arranged in close contact with the solid-state light emitting element 1. As illustrated in Fig. 5, the wavelength converter 2 can also be arranged to enclose the solid-state light emitting element 1.

As illustrated in Fig. 3, the main light receiving surface 2a of the wavelength converter 2 for receiving the primary light 10 can have a larger area than the main light emitting surface 1b of the solid-state light emitting element 1. As illustrated in Figs. 2, 4 and 6, the main light receiving surface 2a of the wavelength converter 2 can have a substantially similar area as the main light emitting surface 1b of the solid-state light emitting element 1.

In the light emitting device according to the present embodiment, the organic polymer member 3 can be in the form of a sheet or a film. However, such an organic polymer member 3 tends to have a wavy shape. Thus, as illustrated in Figs. 2, 3 and 5, a protective member 5 for fixing the organic polymer member 3 may be provided. As the protective member 5, for example, a flat plate may be used. By bringing the organic polymer member 3 into close contact with the protective member 5, flatness of the organic polymer member 3 can be maintained. The flatness of the organic polymer member 3 can also be maintained by combining the organic polymer member 3 with the solid-state light emitting element 1 and the wavelength converter 2 as one body, as illustrated in Fig. 6.

As the protective member 5, a structure made from an organic compound, or a structure made from an inorganic compound that transmits at least a near-infrared ray, can be used. As a material of the protective member 5, acrylic resin, PET (polyethylene terephthalate) resin, glass, or the like can be used.

In the present embodiment, the organic polymer member 3 contains aromatic polyimide. The aromatic polyimide has a structure where aromatic compounds are directly connected through an imide bond. In the aromatic polyimide, adjacent aromatic rings directly linked through an imide bond have a conjugated structure, and a charge transfer complex is formed within and between molecules. Thus, the aromatic polyimide has a property of absorbing part of short-wavelength visible light.

As aromatic polyimide that can be contained in the organic polymer member 3, at least one can be used that is selected from the group consisting of Kapton (registered trademark) manufactured by DU PONT-TORAY CO., LTD., APICAL (registered trademark) manufactured by KANEKA CORPORATION, and Upilex (registered trademark) manufactured by UBE Corporation. Among these, Kapton can be used as the aromatic polyimide. Kapton is made from poly (4,4'-oxydiphenylene-pyromellitimide). Poly (4,4'-oxydiphenylene-pyromellitimide) is polyimide obtained by polymerizing pyromellitic dianhydride and 4,4'-diaminodiphenyl ether.

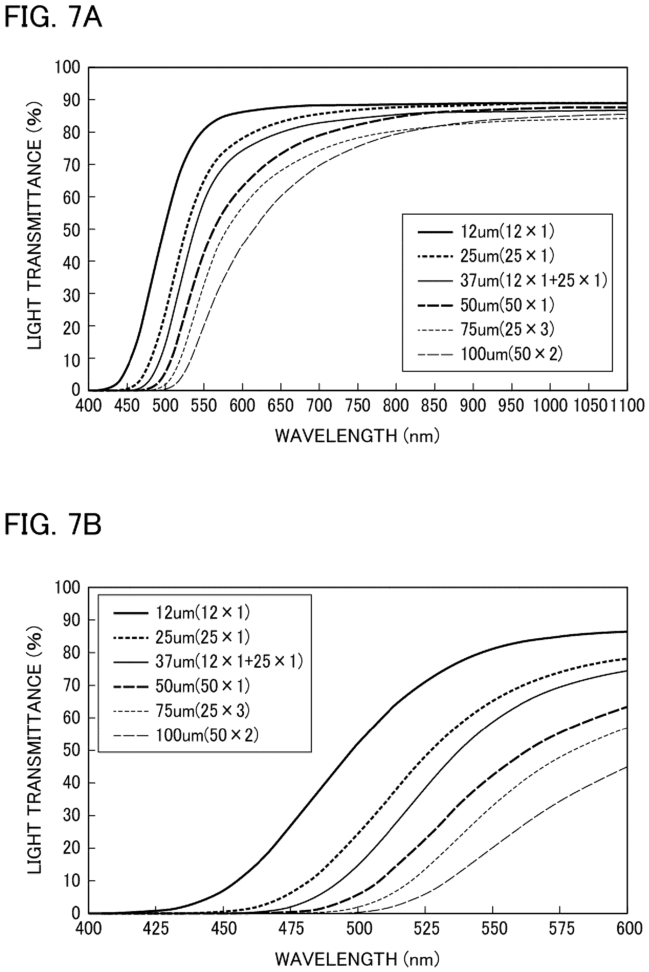

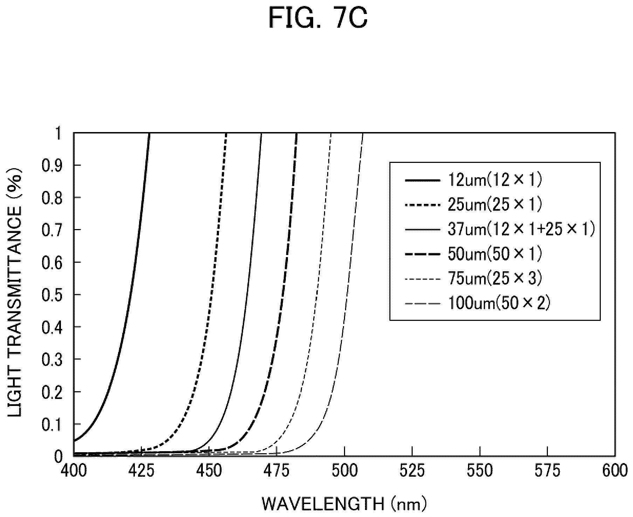

Here, wavelength dependency of a light transmittance of the organic polymer **member** 3 containing aromatic polyimide will be described. Fig. 7A illustrates light transmittances in a wavelength range of 400 nm to 1,100 nm in a Kapton sheet, which is an example of an aromatic polyimide sheet. Figs. 7B and 7C illustrate light transmittances in a wavelength range of 400 nm to 600 nm. Note that in Figs. 7A to 7C, "12 µm (12 × 1)" indicates that one aromatic polyimide sheet having a thickness of 12 µm is used. Also, "37 µm (12 × 1 + 25 × 1)" indicates that one sheet having a thickness of 12 µm and one sheet having a thickness of 25 µm are overlapped, and thus an aromatic polyimide sheet having a total thickness of 37 µm is used. Note that in this specification, the light transmittance of the organic polymer member 3 can be measured in accordance with the Japanese Industrial Standard JIS K7361-1.

As illustrated in Figs. 7A and 7B, aromatic polyimide has a property of controlling transmission of visible light, especially light on the short wavelength side (violet light and blue light), while substantially not controlling transmission of near-infrared light components. A light transmittance of aromatic polyimide in a wavelength range of at least 200 nm or more and less than 400 nm is substantially 0%, and a light transmittance in a wavelength range of at least more than 1,100 nm and less than 2,000 nm maintains a level of a light transmittance at a wavelength of 1,100 nm.

As can be seen from Figs. 7B and 7C, a transmittance of visible light of aromatic polyimide decreases as wavelength becomes shorter, and light having a wavelength of around 450 nm or less is almost blocked. Note that, incidentally, the wavelength of 450 nm is substantially equal to a peak wavelength of light emitted by a common commercially available blue light emitting diode.

As described above, in the light emitting device 100, after the mixed light 12 of the primary light 10A and the wavelength-converted light 11 are transmitted through the organic polymer member 3 containing aromatic polyimide, the transmitted light is output as the output light 13. With this configuration, output of a blue light component is largely decreased in the visible light component of the primary light 10A, and the intensity of a blue-green to green light component contained in a small amount in the primary light 10 is considerably lowered. Then, a yellow to red light component contained in a small amount, and a deep red light component having low visibility in the wavelength-converted light 11 are transmitted through the organic polymer member 3. Consequently, in the spectral distribution of the visible region of the output light 13, a visible light component having an extremely reduced intensity in a wavelength region (of 420 nm or more and less than 660 nm) of high visibility has a constant intensity over the entirety of the wavelength region. Then, a visible light component in the wavelength region (of 420 nm or more and less than 660 nm) having high visibility but reduced intensity is additively mixed with a visible light component in a wavelength region (of 660 nm or more and less than 780 nm) of low visibility to constitute the output light 13. In this way, moderate weak white light is generated through the additive color mixing, and is visually recognized.

In contrast, the near-infrared ray component of the wavelength-converted light 11 is barely absorbed by, and is transmitted through, the organic polymer member 3. Consequently, due to a synergistic effect of weak white light and near-infrared light having high intensity, both dimly shining natural light and a high-output near-infrared ray can be achieved. Thus, the light emitting device 100 has a property of outputting a high-output near-infrared ray, making it possible for a person to recognize a lit state and an unlit state with weak white light, and giving almost no discomfort to the surrounding environment when lit.

Note that aromatic polyimide is known as an indispensable material for advanced industries, and has high mechanical strength and excellent heat resistance (-269 to +400 °C). Aromatic polyimide is also excellent in electrical insulation (380 to 400 kV/mm) and chemical resistance, and has a low expansion rate against heat for an organic material. Furthermore, since aromatic polyimide is an artificially synthesized organic material, its price level is also low compared with optical filters using inorganic materials. Such aromatic polyimide is widely known as "Kapton" as described above, and films and adhesive tapes are commercially available. Thus, with such a configuration, the light emitting device 100 is advantageous in producing and providing inexpensive products with excellent reliability.

Here, as can be seen from Figs. 7B and 7C, a sheet made from aromatic polyimide and having a thickness of 12 µm to 100 µm substantially blocks a light component having a wavelength of 450 nm or less. That is, the sheet blocks light components having a wavelength of 450 nm or less so that a light transmittance at a wavelength of 400 nm or less is less than 0.1%. Note that the wavelength of 450 nm substantially corresponds to a peak wavelength of the primary light 10 of the blue LED.

Further, a sheet made from aromatic polyimide and having a thickness of 12 µm to 100 µm, particularly a sheet having a thickness of 25 µm to 100 µm, has a light transmittance of less than 1%, particularly less than 0.1%, of a light component at a wavelength of 450 nm or less. The sheet has a light transmittance of less than 30% at a wavelength of 500 nm or less, which decreases to less than 20%, or less than 10%, as the thickness increases.

A sheet made from aromatic polyimide and having a thickness of 12 µm to 100 µm has a light transmittance of 75% or more and less than 100% at a wavelength of at least 750 nm or more and less than 1,100 nm. The sheet, when having a thickness of less than 50 µm, has a light transmittance of 80% or more at a wavelength of at least 750 nm or more and less than 1,100 nm.

A sheet made from aromatic polyimide and having a thickness of 12 µm to 100 µm has a light transmittance in 10 nm increments within a wavelength range of 500 nm or more and 750 nm or less, increasing as the wavelength becomes longer.

Note that in consideration of property variations of aromatic polyimide and improved techniques, it is thought that aromatic polyimide having a thickness of 3 µm or more and less than 300 µm, particularly 10 µm or more and less than 120 µm, has light transmission properties similar to those illustrated in Figs. 7B and 7C.

As described above, in the light emitting device 100 according to the present embodiment, a member containing aromatic polyimide can be used as the organic polymer member 3. Further, as the organic polymer member 3, a member containing aromatic polyimide as a main component is preferably used, and a member made from aromatic polyimide is also preferably used. However, the organic polymer member 3 in the present embodiment is not limited to a member containing aromatic polyimide, and even when a member having the following properties is used, it is possible to obtain a light emitting device that achieves both dimly shining white light and a high-output near-infrared ray.

Specifically, in the light emitting device 100 according to the present embodiment, the organic polymer member 3, which has all of the following properties (1) to (6), can be used. (1) The thickness is 3 µm or more and less than 300 µm. (2) The light transmittance at a wavelength of 400 nm or less is less than 0.1%. (3) The light transmittance at or below a wavelength of the emission peak of the primary light 10 is less than 1%. (4) The light transmittance at a wavelength of 500 nm or less is less than 30%. (5) The light transmittance within a wavelength range of 750 nm or more and less than 1,100 nm is 75% or more and less than 100%. (6) The light transmittance in increments of 10 nm within a wavelength range of 500 nm or more and 750 nm or less increases as the wavelength becomes longer. Note that (3) the light transmittance at or below a wavelength of the emission peak of the primary light 10 is more preferably less than 0.1%. Also, (4) the light transmittance at a wavelength of 500 nm or less is preferably less than 20%, and more preferably less than 10%.

In the light emitting device 100 according to the present embodiment, the wavelength converter 2 can be configured not to include a visible phosphor that emits fluorescence having a fluorescence peak within a wavelength range of 380 nm or more and less than 780 nm. In this configuration, a light emitting device can be configured only with the solid-state light emitting element 1, the wavelength converter 2 made from a near-infrared phosphor, and the organic polymer member 3, thereby simplifying the structure of the device. Thus, management of constituent members can be streamlined. In addition, variations in color tones of the mixed light 12 and the output light 13 between lots can be controlled.

In contrast, in the light emitting device 100 according to the present embodiment, the wavelength converter 2 can be configured to include a visible phosphor that emits fluorescence having a fluorescence peak within a wavelength range of 500 nm or more and less than 780 nm. In particular, the wavelength converter 2 can be configured to include a visible phosphor that emits fluorescence having a fluorescence peak within at least one of: a green wavelength range of 500 nm or more and less than 560 nm; or a red-orange to deep red wavelength range of 600 nm or more and less than 780 nm. In this configuration, the light emitting device 100 is advantageous for controlling color tones of the output light 13, which is visually recognized by human eyes.

In the light emitting device 100 according to the present embodiment, the wavelength converter 2 may have a mixed light emitting surface (the main light emitting surface 2b), and the mixed light emitting surface may be configured to emit the mixed light 12. This results in a configuration where the mixed light 12 is transmitted through the organic polymer member 3 only by covering the mixed light emitting surface of the wavelength converter 2 with the organic polymer member 3. Thus, the light emitting device 100 is advantageous for reducing the area of an output light emitting surface 3b in the organic polymer member 3.

In the light emitting device 100 according to the present embodiment, it is preferable that the wavelength converter 2 be configured to absorb at least part of the primary light 10, convert it into the wavelength-converted light 11, and transmit the primary light 10, which has not been absorbed. With this configuration, the wavelength converter 2 and the organic polymer member 3 are overlapped above the main light emitting surface 1b of the solid-state light emitting element 1, and the output light 13 having light components of both visible light and a near-infrared ray is output. Also with this configuration, the light emitting device 100 is advantageous in reducing the area of the output light emitting surface 3b.

In the light emitting device 100 according to the present embodiment, it is preferable that a light output surface (the main light emitting surface 2b) for the mixed light 12 of the wavelength converter 2 have a flat shape. Thus, the organic polymer member 3 in an orthodox sheet can be easily adhered to the wavelength converter 2. Thus, since the wavelength converter 2 and the organic polymer member 3 can be easily formed as one body, the light emitting device 100 is advantageous in achieving compactness.

In the light emitting device 100 according to the present embodiment, the wavelength converter 2 can be a resin fluorescent film where particles of a near-infrared phosphor are dispersed in a resin having translucency. Such a resin fluorescent film is of an orthodox technique used in LED illumination light sources. Thus, the light emitting device 100 is advantageous in manufacturing without worrying about issues in industrial production. Moreover, as illustrated in Fig. 5, it becomes possible to easily manufacture the light emitting device 100D, which has a configuration where the wavelength converter 2 encloses the solid-state light emitting element 1.

In the light emitting device 100 according to the present embodiment, the wavelength converter 2 can be a fluorescent ceramic. The fluorescent ceramic is a sintered body obtained by sintering a near-infrared phosphor, and has excellent heat resistance and thermal conductivity. Thus, the light emitting device 100 having such a configuration is advantageous for high output.

In the light emitting device 100 according to the present embodiment, the organic polymer member 3 can be in the form of a sheet or a film. In this case, since the thickness of the organic polymer member 3 is reduced, the light emitting device 100 is advantageous for thinness. Moreover, in this case, the organic polymer members 3 can be easily overlapped without causing bulkiness. Thus, the light emitting device 100 is advantageous for adjusting transmittances of visible light. Note that the thickness of the organic polymer member 3 is preferably 3 µm or more to less than 300 µm, more preferably 10 µm or more to less than 100 µm, and even more preferably 20 µm or more to 75 µm or less.

In the light emitting device 100 according to the present embodiment, the wavelength converter 2 and the organic polymer member 3 may be bonded using an adhesive material having translucency. Thus, since the wavelength converter 2 and the organic polymer member 3 are formed as one body, it is possible to control color shift of the output light 13 due to positional shift between the wavelength converter 2 and the organic polymer member 3. Moreover, even if the organic polymer member 3 deteriorates, the deteriorated organic polymer member 3 can be peeled off, and a new organic polymer member 3 can be bonded. Note that as the adhesive material, either a silicone resin or an acrylic resin can be used.

Here, a refractive index of aromatic polyimide contained in the organic polymer member 3 is 1.65 or more to 1.70 or less, which is larger than that of air (1.0) and those of silicone resin and acrylic resin (1.40 or more to 1.55 or less). Thus, refractive index steps are generated at the boundary between the aromatic polyimide and air, the boundary between the aromatic polyimide and silicone resin, and the boundary between the aromatic polyimide and acrylic resin, which may reduce the light extraction efficiency.

Thus, when an incident surface (the main light receiving surface 3a) for the mixed light 12 in the organic polymer member 3 is in contact with a low refractive index material having a refractive index smaller than that of the organic polymer member 3, an intermediate refractive index material having a refractive index smaller than that of the organic polymer member 3 and larger than that of the low refractive index material may be arranged on the incident surface. When an output surface (the output light emitting surface 3b) for the output light 13 in the organic polymer member 3 is in contact with a low refractive index material having a refractive index smaller than that of the organic polymer member 3, an intermediate refractive index material having a refractive index smaller than that of the organic polymer member 3 and larger than that of the low refractive index material may be arranged on the output surface. With such a configuration, refractive index steps are relaxed, and the extraction efficiency of the output light 13 can be increased.

Specifically, when the organic polymer member 3 is in close contact with the wavelength converter 2, which includes silicone resin as a main component, via an adhesive material, the adhesive material can be used as an intermediate refractive index material. As the adhesive material, it is preferable to use a material having a refractive index greater than 1.55 and less than 1.65, for example, an epoxy-based resin.

When the organic polymer member 3 is in contact with an air layer, an intermediate refractive index material can be arranged on a surface (the output light emitting surface 3b) in contact with the air layer. In this case, the refractive index of the intermediate refractive index material is preferably less than 1.65, and preferably 1.40 or more to less than 1.55. For example, an intermediate refractive index material can be arranged on the output light emitting surface 3b of the organic polymer member 3 by using a polyimide tape that has been surface-coated with a silicone resin in advance.

Note that the intermediate refractive index material is preferably a member that transmits at least a near-infrared ray.

In the light emitting device 100 according to the present embodiment, the main light emitting surface 2b for the mixed light 12 in the wavelength converter 2 is preferably quadrilateral in shape when viewed along a direction (vertical direction in Fig. 1) where the solid-state light emitting element 1, the wavelength converter 2, and the organic polymer member 3 overlap. The main light emitting surface 2b of the wavelength converter 2 is preferably rectangular in shape, and more preferably square when viewed along the overlapping direction. Here, a plate-like or sheet-like organic polymer member can be used by simply cutting it, and thus the light emitting device 100 is advantageous for industrial production. Furthermore, since the entire main light emitting surface 2b can be covered with the simply cut organic polymer member 3 without excess or lack of material, the output light 13 with less color tone unevenness can be obtained.

In the light emitting device 100 according to the present embodiment, the mixed light 12 preferably includes a blue light component within a wavelength range of 430 nm or more and less than 490 nm, a green light component within a wavelength range of 490 nm or more and less than 550 nm, and a red light component within a wavelength range of 640 nm or more and less than 770 nm. Note that the blue light component is preferably a light component within a wavelength range of 440 nm or more and less than 470 nm. The green light component is preferably a light component within a wavelength range of 510 nm or more and less than 540 nm. The red light component is preferably a light component within a wavelength range of 640 nm or more and less than 700 nm. **In** this case, since the mixed light 12 includes light components of the three primary colors of light, it becomes possible to output white light resulting from additive color mixing of these, as the output light 13.

**In** the light emitting device 100 according to the present embodiment, the mixed light 12 can have a maximum intensity value of visible light having a wavelength of 380 nm or more and less than 780 nm made smaller than a maximum intensity value of a near-infrared ray having a wavelength of 780 nm or more and less than 2,500 nm. In addition, the maximum intensity value of visible light of the mixed light 12 can be 10% or more and less than 50% of the maximum intensity value of a near-infrared ray, or 30% or more and less than 40% thereof. Thus, the light emitting device 100 is advantageous in outputting high-output a near-infrared ray. In addition, the light emitting device 100 is advantageous in outputting the output light 13, which achieves both visible light that is dimly visible to human eyes, and a high-output near-infrared ray.

In the light emitting device 100 according to the present embodiment, the output light 13 preferably has a correlated color temperature of 2,000 K or more and less than 10,000 K, and more preferably 2,500 K or more and less than 7,000 K. An average color rendering index Ra of the output light 13 is preferably 65 or more and less than 100, and more preferably 75 or more and less than 100. This makes it possible to emit visible light close to natural light, so that the light emitting device 100 is advantageous in informing a person of a lit / unlit state without giving a sense of discomfort. Note that the output light 13 having such a correlated color temperature can be implemented in a range where the thickness of the organic polymer member 3 is approximately 35 µm or more and less than 120 nm. The output light 13 having such an average color rendering index Ra can be implemented in a range where the thickness of the organic polymer member 3 is approximately 15 µm or more and less than 120 nm.

The light emitting device 100 according to the present embodiment can be used in a configuration where the output light 13 is directly irradiated to an object to be irradiated. It is also possible to use in a configuration where the output light 13 is indirectly irradiated to an object to be irradiated. In the case of indirect irradiation, the output light 13 is irradiated to a reflector that reflects a near-infrared ray, or a light diffuser that diffuses a near-infrared ray. Then, an object to be irradiated is irradiated with a near-infrared ray reflected by the reflector, or a near-infrared ray diffused by the light diffuser. With such a configuration, since the object to be irradiated is irradiated with a diffused near-infrared ray, a near-infrared ray can be irradiated from multiple directions without unevenness in intensity or color tone. Note that as the reflector and the light diffuser, members formed with an inorganic substance or an organic substance may be used as appropriate.

The light emitting device 100 according to the present embodiment can be widely used in electronic equipment and equipment systems using a near-infrared ray. In the electronic equipment and equipment systems configured by using the light emitting device 100, it is possible for a person to recognize the lit / unlit state of a near-infrared ray without having a sense of discomfort. Thus, instances of forgetting to turn off a near-infrared ray can be reduced. Moreover, even if a person has forgotten to turn off a near-infrared ray, it is possible to gently make the person notice without damaging the illumination environment of a space.

As described above, the near-infrared light emitting device 100 according to the present embodiment includes the solid-state light emitting element 1, which emits the primary light 10 having an emission peak within a wavelength range of 420 nm or more and less than 500 nm. The light emitting device 100 further includes the wavelength converter 2, which converts the primary light 10 into the wavelength-converted light 11 having a fluorescence peak within a wavelength range of 750 nm or more and less than 2,500 nm. The light emitting device 100 further includes the organic polymer member 3, through which the mixed light 12 of the primary light 10A emitted by the solid-state light emitting element 1, and the wavelength-converted light 11 emitted by the wavelength converter 2 is transmitted. The light emitting device 100 then outputs the mixed light 12 transmitted through the organic polymer member 3, as the output light 13. The organic polymer member 3 has the following properties (1) to (6).
(1) The thickness is 3 µm or more and less than 300 µm.
(2) The light transmittance at a wavelength of 400 nm or less is less than 0.1%.
(3) The light transmittance at or below a wavelength of the emission peak of the primary light 10 is less than 1%.
(4) The light transmittance at a wavelength of 500 nm or less is less than 30%.
(5) The light transmittance within a wavelength range of 750 nm or more and less than 1,100 nm is 75% or more and less than 100%.
(6) The light transmittance in increments of 10 nm within a wavelength range of 500 nm or more and 750 nm or less increases as the wavelength becomes longer.

In the light emitting device 100, the organic polymer member 3 has a property of controlling transmission of visible light, especially light on the short wavelength side (violet light and blue light), while substantially not controlling transmission of a near-infrared component. Thus, when the mixed light 12 of the primary light 10A and the wavelength-converted light 11 are transmitted through the organic polymer member 3, output of the blue light component of the primary light 10A is largely reduced, and the blue green to green light component slightly included in the primary light 10A, and the red light component slightly included in the wavelength-converted light 11 are transmitted. Consequently, the visible light component transmitted through the organic polymer member 3 becomes weak white light through additive color mixing, and can be visually recognized. In contrast, the near-infrared component of the wavelength-converted light 11 is transmitted through the organic polymer member 3 almost without being absorbed. As described above, the light emitting device 100 has a configuration where the dimly shining visible light and the strong near-infrared ray are both achieved, and a lit state and an unlit state can be visually recognized.

The near-infrared light emitting device 100 according to the present embodiment also includes the solid-state light emitting element 1, which emits the primary light 10 having an emission peak within a wavelength range of 420 nm or more and less than 500 nm. The light emitting device 100 further includes the wavelength converter 2, which converts the primary light 10 into the wavelength-converted light 11 having a fluorescence peak within a wavelength range of 750 nm or more and less than 2,500 nm. The light emitting device 100 further includes the organic polymer member 3, through which the mixed light 12 of the primary light 10A emitted by the solid-state light emitting element 1, and the wavelength-converted light 11 emitted by the wavelength converter 2 is transmitted, and which contains aromatic polyimide. The light emitting device 100 outputs the mixed light 12 transmitted through the organic polymer member 3, as the output light 13.

Aromatic polyimide has a property of controlling transmission of light (violet light and blue light) on the short wavelength side, and only slight controlling transmission of near-infrared components. Thus, by using aromatic polyimide as the organic polymer member 3, the light emitting device 100 achieves both the dimly shining visible light and the strong near-infrared ray, and enables a lit state and an unlit state to be visually recognized. Aromatic polyimide also has high mechanical strength and excellent heat resistance. Aromatic polyimide is also excellent in electrical insulation and chemical resistance, and has a low expansion coefficient against heat for an organic substance. Since aromatic polyimide is an organic substance artificially synthesized, it is also inexpensive. Therefore, by using aromatic polyimide as the organic polymer member 3, a light emitting device having excellent reliability and low cost can be obtained.

Note that the present embodiment can be regarded as a novel method for making a person recognize a lit state and an unlit state of the near-infrared light emitting device 100, which exclusively emits a near-infrared ray. Specifically, the present embodiment can be regarded as a method for confirming the lit state or unlit state of the near-infrared light emitting device 100 emitting a near-infrared ray, where the mixed light 12 of the near-infrared ray and visible light having a lower intensity than the near-infrared ray is transmitted through the organic polymer member 3 to be output as white light.

### [Method for adjusting an intensity ratio of a near-infrared ray to a visible ray]

Next, a method for adjusting an intensity ratio of a near-infrared ray to a visible ray according to the present embodiment will be described.

As described above, the organic polymer member 3 has a property that, while controlling transmission of visible light, particularly light on the short wavelength side (violet light and blue light), it substantially does not control transmission of near-infrared light. Thus, by causing mixed light of near-infrared light and visible light to be transmitted through the organic polymer member 3, near-infrared light can be efficiently transmitted while greatly controlling output of visible light, particularly violet light and blue light.

As described above, transmission of visible light, particularly violet light and blue light, is controlled by causing mixed light of near-infrared light and visible light to be transmitted through the organic polymer member 3, and thus using the organic polymer member 3 enables the intensity ratio of near-infrared light to visible light to be adjusted. Therefore, the present embodiment can be regarded as a novel method for adjusting the intensity ratio of near-infrared light to visible light with respect to mixed light of the near-infrared light and visible light.

Specifically, the present embodiment is a method for adjusting the intensity ratio of a near-infrared ray to a visible ray in the near-infrared light emitting device 100, which outputs a near-infrared ray, and a visible ray having an intensity smaller than that of the near-infrared ray, where the mixed light 12 of the near-infrared ray and the visible ray is transmitted through and is output from the organic polymer member 3.

The method for adjusting the intensity ratio of a near-infrared ray and a visible ray according to the present embodiment includes a step for causing the mixed light 12 of the primary light 10 having an emission peak in a wavelength range of 420 nm or more and less than 500 nm, and the wavelength-converted light 11 obtained through wavelength conversion of the primary light 10 and having a fluorescence peak in a wavelength range of 750 nm or more and less than 2,500 nm to be transmitted through the organic polymer member 3. The adjustment method further includes a step for outputting the mixed light 12 transmitted through the organic polymer member 3, as the output light 13. The organic polymer member 3 has the following properties (1) to (6).
(1) The thickness is 3 µm or more and less than 300 µm.
(2) The light transmittance at a wavelength of 400 nm or less is less than 0.1%.
(3) The light transmittance at or below a wavelength of the emission peak of the primary light 10 is less than 1%.
(4) The light transmittance at a wavelength of 500 nm or less is less than 30%.
(5) The light transmittance within a wavelength range of 750 nm or more and less than 1,100 nm is 75% or more to less than 100%.
(6) The light transmittance in increments of 10 nm within a wavelength range of 500 nm or more and 750 nm or less increases as the wavelength becomes longer.

Here, as described above, as the thickness of the organic polymer member 3 increases, the transmission of light on the short wavelength side can be controlled. Specifically, as illustrated in Fig. 7, when the organic polymer member 3 is made from aromatic polyimide, as the thickness of the organic polymer member 3 increases, the light transmittance of visible light at a wavelength of 380 nm or more and less than 780 nm decreases, and in particular, as the wavelength becomes shorter, the light transmittance decreases. **In** this manner, as the thickness of the organic polymer member 3 increases, the light on the short wavelength side is blocked, and thus the correlated color temperature of the output light 13 transmitted through the organic polymer member 3 can be lowered.

In this manner, as the thickness of the organic polymer member 3 increases, the light transmittance of visible light decreases, and in particular, as the wavelength becomes shorter, the light transmittance decreases. Thus, adjusting the thickness of the organic polymer member 3 also enables color tone of visible light to be adjusted. Therefore, the present embodiment can be regarded as a novel method for adjusting the color tone of visible light with respect to the mixed light of near-infrared light and visible light.

Specifically, the present embodiment is a method for adjusting a color tone of a visible ray in the near-infrared light emitting device 100 outputting a near-infrared ray and a visible ray, and is a method for adjusting a color tone of the output light 13, wherein the mixed light 12 of a near-infrared ray and a visible ray is transmitted through and is output from the organic polymer member 3.

### EXAMPLES

The present embodiment will be described in more detail below with reference to examples and comparative examples, but the present embodiment is not limited to these examples.

### [Example 1]

First, a near-infrared light emitting device according to example 1 was manufactured using the following members.
(1) LED base light with light control function, manufactured by Panasonic Corporation, product number NDNN52500 DK9, power consumption 14 W
(2) Near-infrared LED package, externally procured item, surface mount (SMD) type, length 3 mm, width 3 mm, power consumption 460 mW
(3) Polyimide adhesive tape (organic polymer member), thickness 50 µm

The LED base light is lighting equipment having a structure where two types of white LED packages with different light colors are alternately arranged in a straight line at equal intervals of 32 packages each. The two types of white LED packages are day white and incandescent colors, and they are all SMD type. The LED base light has a control circuit to independently control electric power inputted to white LEDs of day white and incandescent colors, thereby controlling light color of white light emitted by the LED base light.

The near-infrared LED package is an LED package that combines a blue LED and a near-infrared phosphor. In general, a prototype can be manufactured by informing a manufacturer who has manufacturing techniques of LED packages using an inorganic phosphor of a desired specification (spectral distribution, driving voltage, current, size, etc.) and requesting a prototype. Note that "near-infrared LED package" is also referred to as "near-infrared LED" below.

The polyimide adhesive tape, known as "Kapton (registered trademark) tape", is an adhesive tape containing aromatic polyimide. Such polyimide adhesive tapes having different thicknesses and tape widths are commercially available as general-purpose products. Note that "polyimide adhesive tape" is also referred to as "polyimide tape" below.

Specifically, first, an illumination glove provided on the front of the LED base light was removed to expose a total of 64 white LEDs of the LED base light. Note that the illumination glove of the LED base light has a structure that is easy to attach and detach. Next, of the 64 white LEDs, white LEDs having an incandescent color (32) were all removed. Next, 32 near-infrared LEDs were attached to the removed locations. Then, a lighting test was performed to confirm that there was no electrical connection failure in the replaced near-infrared LEDs. Then, the polyimide tape was attached to cover the entire surface of light output surfaces of the 32 near-infrared LEDs.

In this way, the light emitting device of the present example was obtained, which was provided with white LEDs that emit white light having a day white color, and near-infrared LEDs that emit a near-infrared ray, and could independently control the output of day white light and the output of near-infrared light. Note that in this example, for the purpose of simplifying the configuration of the device, the detached illumination glove was not attached. However, the illumination glove could also be attached.

### [Comparative example 1]

A light emitting device of the present example was obtained through the same process as in example 1, except that a polyimide tape was not attached to the light output surfaces of the near-infrared LEDs.

### [Comparative example 2]

A light emitting device of the present example was obtained through the same process as in example 1, except that a YAG fluorescent film (thickness: 150 µm) was attached to the light output surfaces of the near-infrared LEDs instead of a polyimide tape.

Note that the YAG fluorescent film was prepared as follows. First, a YAG phosphor powder represented by a general formula of Y₃Al₅O₁₂:Ce³⁺ obtained from a phosphor manufacturer, and a transparent silicone resin were prepared. Note that a fluorescent color of a YAG phosphor was yellow green. Next, the YAG phosphor powder and the transparent silicone resin were weighed in such a manner that their volume ratios were 10% and 90% (the weight ratio is YAG : agent A: agent B ≈ 1 : 1 : 1), and these were mixed to obtain a phosphor paste (total amount about 3 g). Next, the obtained phosphor paste was put into a die, and then thermally cured at a temperature of 100 to 150 °C to obtain a YAG phosphor film.

### [Evaluation of the light emitting devices of example 1, and comparative examples 1 and 2]

After the near-infrared light emitting device of example 1 obtained as described above was energized and turned on, a spectral distribution of its output light was evaluated. However, for convenience, the following describes a case where white LEDs are turned off by using a light control function of lighting equipment, and only near-infrared LEDs are turned on. Note that the near-infrared light emitting device of example 1 can also turn on the white LEDs by using the light control function of the lighting equipment. The intensity ratio of the near-infrared ray to white light can be changed, and the intensity of output of the near-infrared ray can also be adjusted.

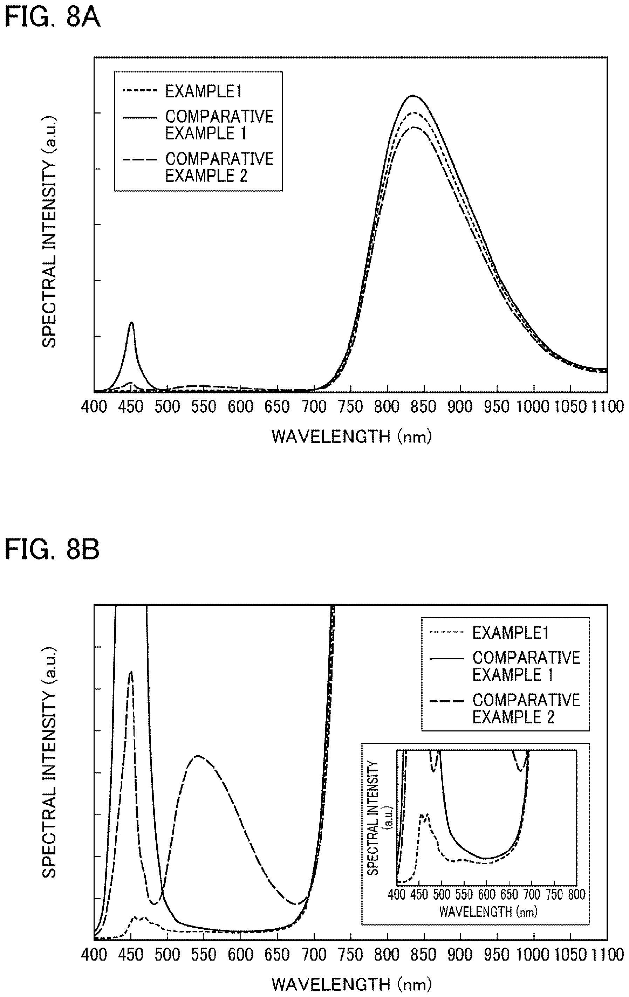

Fig. 8A is a graph illustrating spectral distributions of output light emitted by the near-infrared light emitting devices of example 1, comparative example 1, and comparative example 2. For reference, an enlarged view of a visible region in the spectral distributions of Fig. 8A is illustrated in Fig. 8B. From Figs. 8A and 8B, the spectral distribution of output light emitted by the light emitting device of example 1 is made from a very weak visible light component having an intensity in a wavelength region of 400 nm or more and less than 610 nm, and a strong near-infrared ray component located in a near-infrared region (780 nm to 2.5 µm). Note that the wavelength region of 400 nm or more and less than 610 nm is a region where dark visibility of the visible region (380 to 780 nm) is relatively high. The visible light component had a light component over the entirety of a wavelength range of at least 420 nm or more and less than 780 nm, and the near-infrared ray component had a light component over the entirety of a wavelength range of at least 780 nm or more and less than 1,100 nm. Therefore, the visible light component of output light emitted by the light emitting device of example 1 was visually recognized as weak white light dimly shining in the dark.

Here, a ratio of maximum intensity values of a dark place-high visibility-light component that was a light component of a wavelength range of 400 nm or more and less than 610 nm, to a near-infrared ray component was examined. Consequently, the maximum intensity value of the dark place-high visibility-light component was 0.27% of the maximum intensity value of the near-infrared ray component, which was a value not only less than 1% but even less than 0.3%.

Next, a spectral distribution of the dark place-high visibility-light component and the near-infrared ray component in the output light of example 1 will be described. As illustrated in Fig. 8B, the dark place-high visibility-light component had a relatively strong light component (blue) within a wavelength range of 460 nm or more and less than 500 nm. The intensity fluctuation range of a light component (blue green to red) within a wavelength range of 500 nm or more and less than 610 nm was small, and the minimum intensity exceeded 80% of the maximum intensity. In addition, the intensity of the visible light component having a wavelength longer than 610 nm increased as the wavelength increased.

In contrast, the intensity of the near-infrared ray component gradually increased as the wavelength increased at least within a wavelength range of 780 nm or more and less than 1,100 nm, as illustrated in Fig. 8A. The near-infrared ray component had a maximum intensity value within a wavelength range of 800 nm or more and less than 950 nm (particularly, less than 900 nm). The intensity of the near-infrared ray component gradually decreased when the wavelength exceeded 950 nm.

Note that the near-infrared ray component in the output light of the light emitting device of example 1 is highly likely to be fluorescence based on an electron energy transition of a trivalent chromium ion of a Cr³⁺ activated phosphor, in light of the desired specifications informed to the package manufacturer of near-infrared LEDs and known techniques.

Next, the difference between output light of the light emitting device of example 1, and output light of the light emitting devices of comparative examples 1 and 2 will be described. As illustrated in Figs. 8A and 8B, in the spectral distribution of the output light of comparative example 1, the maximum intensity value of a near-infrared ray around the wavelength of 840 nm was about 106% of that of example 1. In contrast, in the spectral distribution of output light of comparative example 1, the maximum intensity value of the blue light component around the wavelength of 450 nm was 9,275% (93 times) of that of example 1. Furthermore, comparative example 1 had few visible light components (green to red) other than blue light, and had a blue-biased visible light component.

Thus, while the light emitting device of example 1 emitted output light that achieved both the white light dimly shining in the dark, and the strong near-infrared ray, the light emitting device of comparative example 1 emitted relatively strong blue light, and a strong near-infrared ray. Consequently, it was evident that example 1 had an advantageous effect that output light appeared dimly white without any discomfort, and comparative example 1 outputted strong light with a bluish tinge that is easy to cause discomfort when lit.

Further, as illustrated in Figs. 8A and 8B, in the spectral distribution of the output light of comparative example 2, the maximum intensity value of a near-infrared ray at a wavelength of about 840 nm was about 95% of that of example 1. In contrast, the maximum intensity value of a blue light component at a wavelength of about 450 nm was 1,192% (12 times) of that of example 1. Further, the intensity of a visible light component (green to red) other than the blue light of comparative example 2 was relatively high, and for example, the maximum intensity value within a wavelength range of 500 nm or more and less than 650 nm was 1,737% (17 times) of that of example 1.

Thus, while example 1 emitted output light achieving both the dimly shining white light and the strong near-infrared ray, comparative example 2 emitted relatively strong white light, and a near-infrared ray with relatively low intensity. Consequently, it was evident that comparative example 2 emitted bright white light, and a near-infrared ray with low intensity when lit, and example 1 had an advantageous effect in that output light appeared white and dim without any discomfort.

Here, the spectral distribution of output light of the near-infrared light emitting device according to the present embodiment is substantially determined by the total thickness of the polyimide tape, regardless of the thickness per sheet and the number of overlapped sheets of the polyimide tape. Thus, the spectral distribution of output light of the near-infrared light emitting device was evaluated by changing the total thickness of the polyimide tape.

### [Example 2]

A light emitting device having the configuration illustrated in Fig. 1 was manufactured using one of the near-infrared LEDs used in example 1, and a polyimide tape. Specifically, a polyimide tape (Kapton tape) was attached to cover the entire light output surface of the near-infrared LED used in example 1. Note that in this example, multiple sheets of the polyimide tape were overlapped so that the total thickness was 35 µm. Thus, the light emitting device of this example was obtained, where the polyimide tape was provided on the surface of the near-infrared LED.

### [Examples 3 to 6]

Light emitting devices of examples 3, 4, 5, and 6 were obtained through the same process as in example 2 except that the polyimide tape was overlapped so that the total thickness of the polyimide tape was 50 µm, 85 µm, 100 µm, and 160 µm, respectively.

### [Comparative example 3]

The light emitting device of this example was obtained through the same process as in example 2 except that a polyimide tape was not attached to the light output surface of the near-infrared LED.

### [Evaluation of the light emitting devices of examples 2 to 6, and comparative example 3]

The light emitting devices of examples 2 to 6, and comparative example 3, obtained as described above, were energized and turned on under the same conditions, and spectral distributions of output light were evaluated.

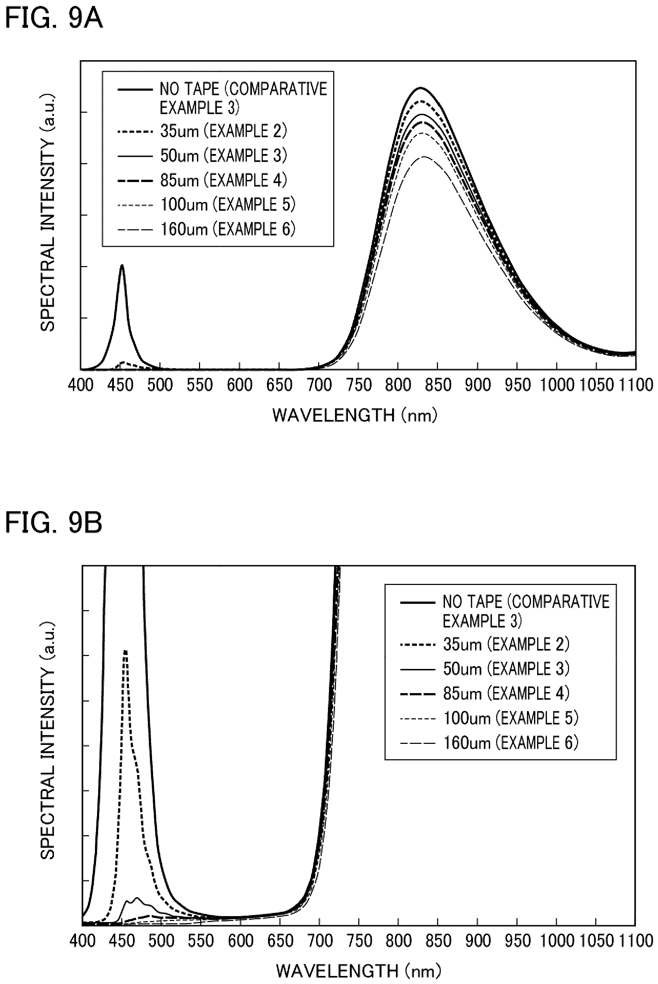

Fig. 9A is a graph illustrating spectral distributions of output light emitted by the light emitting devices of examples 2 to 6, and comparative example 3. For reference, an enlarged view of visible regions in the spectral distributions of Fig. 9A is illustrated in Fig. 9B. As illustrated in Figs. 9A and 9B, spectral distributions of output light emitted by the light emitting device of examples 2 to 6 are made from a very weak visible light component located in the visible region (380 to 780 nm), and a strong near-infrared ray component located in the near-infrared region (780 nm to 2.5 µm), as in example 1. The visible light component had a light component over the entirety of a wavelength range of at least 510 nm or more and less than 780 nm, and the near-infrared ray component had a light component over the entirety of a wavelength range of at least 780 nm or more and less than 1,100 nm.

Note that in examples 2, 3, 4, and 5, the visible light component had a light component in wavelength regions of 410 nm, 430 nm, 450 nm, and 460 nm or more, respectively. Thus, although there were differences in light color, the visible light components of output light emitted by the light emitting device of examples 2 to 6 were visually recognized as weak white light dimly shining in the dark.

Here, the ratio of maximum intensity values of the dark place-high visibility-light component which is a light component within a wavelength of 400 nm or more and less than 610 nm and the near-infrared component was examined. Consequently, the maximum intensity values of the dark place-high visibility-light component in examples 2, 3, 4, 5, and 6 were 2.98%, 0.31%, 0.10%, 0.09%, and 0.08% of the maximum intensity values of the near-infrared ray component, respectively. That is, the maximum intensity values of the dark place-high visibility-light component in examples 2, 3, 4, 5, and 6 were less than 3% of the maximum intensity values of the near-infrared ray component. Note that the intensity ratio was less than 0.5% in examples 3 to 6, and was 0.1% or less in examples 4 to 6.

Next, spectral distributions of the dark place-high visibility-light component and the near-infrared ray component in output light of examples 2 to 6 will be described. As illustrated in Fig. 9B, the dark place-high visibility-light component of examples 2 to 4 had a peak in a wavelength range of 400 nm or more and less than 500 nm, and a light component (blue) in a wavelength range of 460 nm or more and less than 500 nm was relatively strong. An intensity fluctuation range of a light component (blue green to red) within a wavelength range of 550 nm or more and less than 610 nm was small, and the minimum intensity exceeded 80% of the maximum intensity. Note that the intensity of the visible light component having a wavelength longer than 610 nm increased as the wavelength increased.

**In** contrast, the dark place-high visibility-light component of examples 5 and 6 did not have a peak within a wavelength range of 400 nm or more and less than 610 nm. Further, in the dark place-high visibility-light component, the maximum intensity value of a light component within a wavelength range of 500 nm or more and less than 610 nm was larger than the maximum intensity value of a light component within a wavelength range of 400 nm or more and less than 500 nm. The intensity of the dark place-high visibility-light component having a wavelength longer than 550 nm increased as the wavelength increased. Note that the intensity of the visible light component having a wavelength longer than 610 nm increased as the wavelength increased, as in examples 2 to 4.

In contrast, as can be seen from Figs. 8A and 9A, the near-infrared ray component of examples 2 to 6 exhibited spectral distributions similar to that of Example 1.

Next, differences between output light of the light emitting devices of examples 2 to 6, and output light of the light emitting device of comparative example 3, will be described. As illustrated in Figs. 9A and 9B, in the spectral distribution of the output light of comparative example 3, the maximum intensity value of a near-infrared ray near a wavelength of 840 nm was 105%, 110%, 114%, 119%, and 132%, respectively, when compared with the spectral distributions of examples 2, 3, 4, 5 and 6. **In** contrast, the maximum intensity value of the dark place-high visibility-light component of comparative example 3 was 1,308% (13 times), 13,334% (133 times), 40,337% (403 times), 51,736% (517 times), and 61,946% (619 times), respectively, when compared with examples 2, 3, 4, 5, and 6. Comparative example 3 had few visible light components (green to red) other than blue light, and had a blue-biased visible light component.

Thus, while examples 2 to 6, especially examples 3 to 6, emitted output light that achieved both the white light dimly shining in the dark, and the strong near-infrared ray, comparative example 3 emitted relatively strong blue light, and a strong near-infrared ray. Consequently, it was evident that examples 2 to 6 had an advantageous effect that output light appeared dimly white without any discomfort, and comparative example 3 outputted strong light with a bluish tinge that is easy to cause discomfort when lit.

### [Examples 7 to 9]

Light emitting devices of examples 7, 8 and 9 were obtained through the same process as in example 2, except that the polyimide tape was overlapped so that the total thicknesses were 25 µm, 37 µm, and 75 µm, respectively.

### [Evaluation of the light emitting devices of examples 7 to 9]

The light emitting devices of examples 7 to 9 obtained as described above were energized and turned on under the same conditions as in examples 2 to 6, and their output light was evaluated. Specifically, light color (correlated color temperature) of the output light, chromaticity xy on the CIE chromaticity diagram and deviation from black body radiation (deviation duv), and an average color rendering index Ra were evaluated. Also for the light emitting devices of example 3 (total thickness 50 µm), example 5 (total thickness 100 µm), and comparative example 3 described above, the light color (correlated color temperature) of the output light, the chromaticity xy on the CIE chromaticity diagram and the deviation from the black body radiation (deviation duv), and the average color rendering index Ra were evaluated.

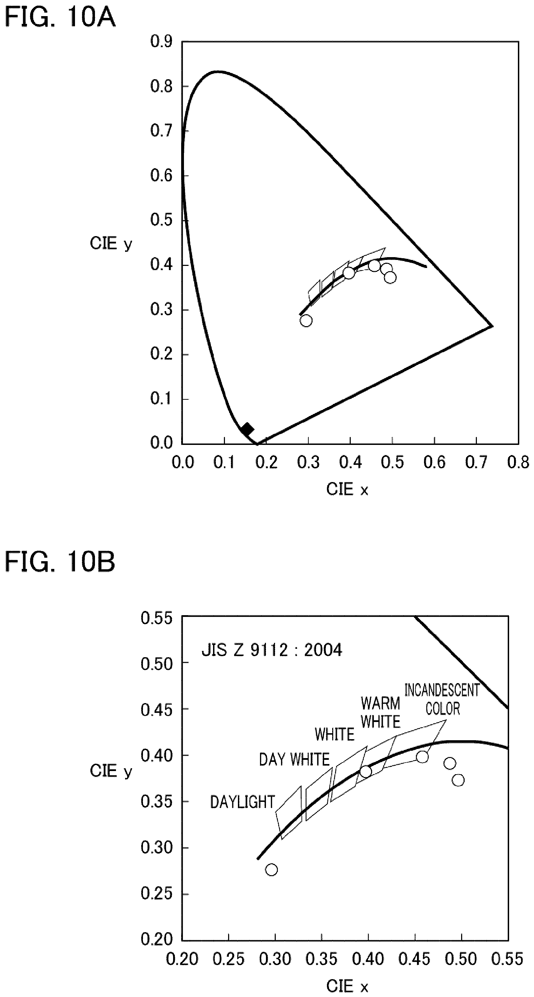

Figs. 10A and 10B are diagrams summarizing color tones of output light of the light emitting devices of examples 3, 5, and 7 to 9, and comparative example 3 on the CIE chromaticity diagram. For reference, Figs. 10A and 10B also illustrate ranges of color types (daylight, day white, white, warm white, incandescent color) of white light in the CIE chromaticity diagram. Table 1 summarizes numerical data of the correlated color temperature, the chromaticity coordinate xy, the deviation duv, and the average color rendering index Ra.

**[Table 1]**

| | Thickness of polyimide tape (µm) | Correlated color temperature (K) | Chromaticity coordinate x | Chromaticity coordinate y | Deviation duv | Average color rendering index Ra |
|---|---|---|---|---|---|---|
| Example 7 | 25 | 8969 | 0.2955 | 0.2763 | -0.02 | 48.3 |
| Example 8 | 37 | 3609 | 0.3974 | 0.3819 | 0 | 67.7 |
| Example 3 | 50 | 2632 | 0.4576 | 0.398 | -0.01 | 75.8 |
| Example 9 | 75 | 2215 | 0.4874 | 0.3909 | -0.01 | 79.9 |
| Example 5 | 100 | 2004 | 0.496 | 0.3729 | -0.01 | 81.9 |
| Comparative example 3 | 0 | - | 0.155 | 0.0033 | - | - |

As illustrated in Figs. 10A and 10B, and Table 1, in examples 3, 5, and 7 to 9 where the thickness of the polyimide tape was within a range of 25 µm or more and 100 µm or less, output light whose light color is white could be obtained.

Note that as for the output light having a white color, the correlated color temperature tended to decrease, and the average color rendering index tended to increase, as the thickness of the polyimide tape increased. In the case of this example, the correlated color temperature could be controlled within a range of approximately 2,000 K or more and less than 9,000 K by changing the thickness of the polyimide tape. That is, the correlated color temperature could be controlled within a range of an incandescent color to a daylight color. The average color rendering index Ra could be controlled within a range of approximately 45 or more and less than 85.

In particular, in examples 3, 9, and 5, output light was emitted having a low color temperature of 3,000 K or less, which was likely to be seen more dimly in the dark, and which had the average color rendering index Ra exceeding 75. At a low color temperature of less than 2,200 K, the average color rendering index is considered to exceed 80. Thus, it was evident that the light emitting device according to the present embodiment, which emitted output light at such a low color temperature, was preferable in order to give an illuminated object a more natural appearance.

Note that what should be noted is the deviation duv. In the light emitting device according to the present embodiment, even when the thickness of the polyimide tape is changed, there is no significant deviation from the locus of black body radiation. That is, the deviation duv is within a range of 0.00 ± 0.02, and it was evident that according to the present embodiment, white light close to natural light could be obtained.

In this way, by using an aromatic polyimide tape or an aromatic polyimide film, a light emitting device can be provided that outputs a high-output near-infrared ray and that causes a lit / unlit state of the near-infrared ray to be visually recognized in the dark with slightly shining white light, without any discomfort.

Although the present embodiment has been described above, the present embodiment is not limited thereto, and various modifications are possible within the scope of the gist of the present embodiment.

The entire contents of Japanese Patent Application No. 2022-070021 (filed April 21, 2022) are incorporated herein by reference.

### INDUSTRIAL APPLICABILITY

The present disclosure provides a near-infrared light emitting device that enables a lit state or an unlit state to be easily recognized, gives little discomfort with visible light when lit, and is capable of efficiently outputting a near-infrared ray, and provides a method for adjusting an intensity ratio between a near-infrared ray and a visible ray.

### REFERENCE SIGNS LIST

1 Solid-state light emitting element
2 Wavelength converter
3 Organic polymer member
10, 10A Primary light
11 Wavelength-converted light
12 Mixed light
13 Output light
100, 100A, 100B, 100C, 100D, 100E Near-infrared light emitting device

## Claims

1. A near-infrared light emitting device, comprising:
a solid-state light emitting element that emits primary light having an emission peak within a wavelength range of 420 nm or more and less than 500 nm;
a wavelength converter that converts the primary light into wavelength-converted light having a fluorescence peak within a wavelength range of 750 nm or more and less than 2,500 nm; and
an organic polymer member through which mixed light of the primary light emitted by the solid-state light emitting element and the wavelength-converted light emitted by the wavelength converter is transmitted, wherein
the organic polymer member has:
a thickness of 3 µm or more and less than 300 µm;
a light transmittance of less than 0.1% at a wavelength of 400 nm or less, a light transmittance of less than 1% at or below a wavelength of the emission peak of the primary light, and a light transmittance of less than 30% at a wavelength of 500 nm or less;
a light transmittance of 75% or more and less than 100% within a wavelength range of 750 nm or more and less than 1,100 nm; and
a light transmittance in 10 nm increments within a wavelength range of 500 nm or more and 750 nm or less increasing as wavelength increases, and
the near-infrared light emitting device outputs the mixed light transmitted through the organic polymer member, as output light.

2. A near-infrared light emitting device, comprising:
a solid-state light emitting element that emits primary light having an emission peak within a wavelength range of 420 nm or more and less than 500 nm;
a wavelength converter that converts the primary light into wavelength-converted light having a fluorescence peak within a wavelength range of 750 nm or more and less than 2,500 nm; and
an organic polymer member through which mixed light of the primary light emitted by the solid-state light emitting element and the wavelength-converted light emitted by the wavelength converter is transmitted, and that includes aromatic polyimide, wherein
the near-infrared light emitting device outputs the mixed light transmitted through the organic polymer member, as output light.

3. The near-infrared light emitting device according to claim 1, wherein the organic polymer member includes aromatic polyimide.

4. The near-infrared light emitting device according to any one of claims 1 to 3, wherein the solid-state light emitting element is a light emitting diode.

5. The near-infrared light emitting device according to any one of claims 1 to 4, wherein the wavelength converter includes a near-infrared phosphor that emits fluorescence having a fluorescence peak within a wavelength range of 780 nm or more and less than 2,500 nm.

6. The near-infrared light emitting device according to any one of claims 1 to 5, wherein the wavelength converter does not include a visible phosphor that emits fluorescence having a fluorescence peak within a wavelength range of 380 nm or more and less than 780 nm.

7. The near-infrared light emitting device according to any one of claims 1 to 6, wherein the organic polymer member has a shape of a sheet, or a shape of a film.

8. The near-infrared light emitting device according to any one of claims 1 to 7, wherein the organic polymer member has a thickness of 10 µm or more and less than 100 µm.

9. The near-infrared light emitting device according to any one of claims 1 to 8, wherein the output light includes white light.

10. A method for adjusting an intensity ratio between a near-infrared ray and a visible ray, comprising:
causing mixed light including: primary light that has an emission peak within a wavelength range of 420 nm or more and less than 500 nm; and wavelength-converted light that is obtained by performing wavelength conversion of the primary light and that has a fluorescence peak within a wavelength range of 750 nm or more and less than 2,500 nm, to be transmitted through an organic polymer member; and
outputting the mixed light transmitted through the organic polymer member, as output light, wherein
the organic polymer member has:
a thickness of 3 µm or more and less than 300 µm;
a light transmittance of less than 0.1% at a wavelength of 400 nm or less, a light transmittance of less than 1% at or below a wavelength of the emission peak of the primary light, and a light transmittance of less than 30% at a wavelength of 500 nm or less;
a light transmittance of 75% or more and less than 100% within a wavelength range of 750 nm or more and less than 1,100 nm; and
a light transmittance in 10 nm increments within a wavelength range of 500 nm or more and 750 nm or less increasing as a wavelength increases.
